# EUROPEAN PATENT APPLICATION

(11) **EP 4 369 413 A1**
(43) Date of publication of application: **15.05.2024**
(21) Application number: 23207667.9
(22) Date of filing: 03.11.2023
(51) Int. Cl.: H01L 29/423, H01L 29/66, H01L 29/788

(54) **MULTI-TIME PROGRAMMABLE MEMORY CELL AND METHOD THEREFOR**

(30) Priority: 11.11.2022 US 202218054614
(71) Applicant: NXP B.V., 5656 AG Eindhoven (NL)
(72) Inventor: Boter, Johan Dick, 5656AG Eindhoven (NL); Dubois, Jerome Guillaume Anna, 5656AG Eindhoven (NL); van Duuren, Michiel Jos, 5656AG Eindhoven (NL)
(74) Representative: Hardingham, Christopher Mark

(57) **Abstract**

A multi-time programmable memory cell is provided. The multi-time programmable memory cell includes a floating gate formed on a field oxide region formed on a semiconductor substrate. A control gate is formed on the field oxide region and located parallel to a first portion of the floating gate. A program-erase electrode is formed on the field oxide region and proximate to a second portion of the floating gate. A first well region and a second well region are formed in the semiconductor substrate such that a channel region is formed between the first well region and the second well region with a third portion of the floating gate overlaying the channel region.

## Description

### Background

### Field

This disclosure relates generally to semiconductor devices, and more specifically, to multi-time programmable (MTP) memory cell and method of forming the same.

### Related Art

Modern semiconductor devices and semiconductor device fabrication processes are fairly well known. For example, non-volatile memories are commonly used in a variety of different applications and electronic products - from sewing machines to washing machines, from automobiles to cellular telephones, and so on. As process technology progresses, these semiconductor devices are expected to reduce in size and cost while increasing performance. However, challenges exist in balancing size, cost, performance, and long-term reliability.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified plan view, an example multi-time programmable (MTP) memory cell in accordance with an embodiment.
FIG. 2 illustrates, in a simplified cross-sectional view, an example programming and erase portion of the example MTP memory cell in accordance with an embodiment.
FIG. 3 illustrates, in a simplified cross-sectional view, an alternative example programming and erase portion of the example MTP memory cell in accordance with an embodiment.
FIG. 4 illustrates, in a simplified cross-sectional view, an example read portion of the example MTP memory cell in accordance with an embodiment.
FIG. 5 illustrates, in a simplified plan view, the example MTP memory cell with an alternative read portion in accordance with an embodiment.
FIG. 6 illustrates, in a simplified cross-sectional view, the alternative example read portion of the example MTP memory cell in accordance with an embodiment.
FIG. 7 illustrates, in a simplified schematic view, the example MTP memory cell in accordance with an embodiment.

### Detailed Description

Generally, there is provided, a multi-time programmable (MTP) non-volatile memory cell. Features such as floating gate, control gate, program-erase electrode, and read transistor of the MTP memory cell are all formed on a field oxide region. The program-erase electrode is separated from the floating gate by a predetermined tunneling distance. During programming and erasing operations, respective program or erase voltages are applied across the program-erase electrode and the control gate electrode. A read transistor is formed having a first well region as a source current electrode region, a second well region as a drain current electrode region, and a portion of the floating gate formed over a channel separating the first and second well regions. Reading the value stored in the MTP memory cell 100 may be performed with a read voltage applied to the control gate electrode, the source current electrode coupled to a power supply node, and the drain current electrode coupled to a bit-line. By forming the floating gate, control gate, program-erase electrode, and read transistor features of the MTP memory cell on the field oxide region (e.g., none of these features being formed on gate oxide), greater scalability with advance (e.g., smaller geometry) technology nodes may be readily accommodated.

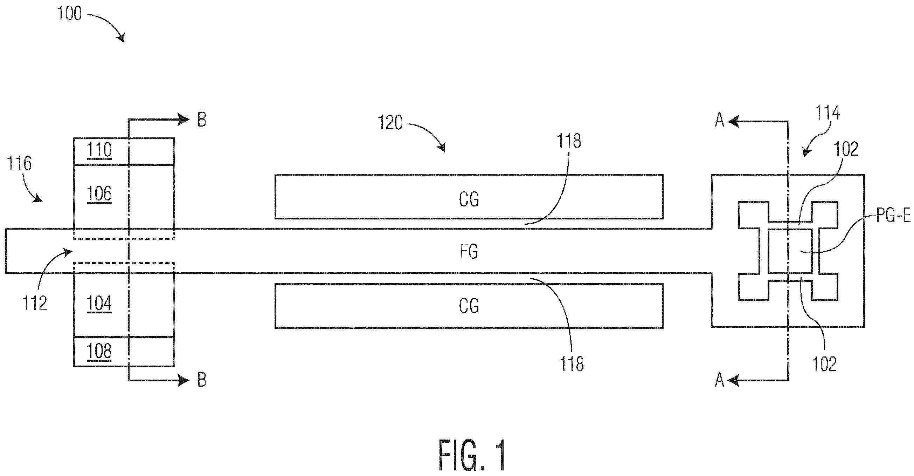

FIG. 1 illustrates, in a simplified plan view, an example MTP non-volatile memory cell 100 at a stage of manufacture in accordance with an embodiment. At this stage, the MTP memory cell 100 includes a program-erase structure 114, a read transistor structure 116, and a control structure 120 formed over a semiconductor substrate (not shown). Conductive feature such as metal traces, vias, etc. interconnected with features of the MTP memory cell 100 are not shown for illustration purposes. The term "conductive," as used herein, generally refers to electrical conductivity unless otherwise described.

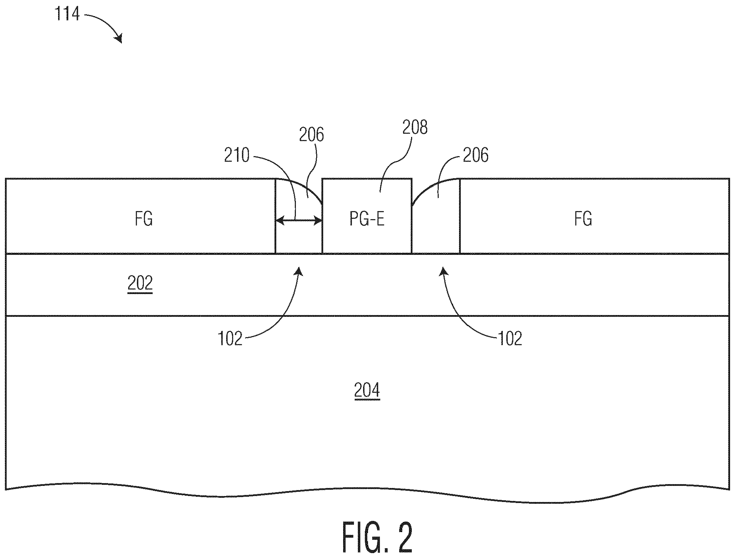

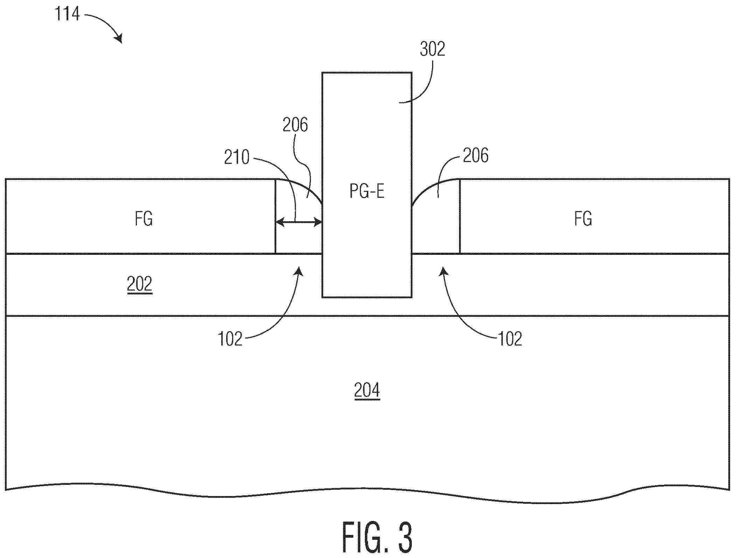

In this embodiment, the program-erase structure 114 of the MTP memory cell 100 includes a conductive program-erase electrode PG-E formed proximate (e.g., very close) to a portion of a conductive floating gate FG. Edges of the program-erase electrode PG-E are spaced apart from the floating gate FG by a tunneling region 102. It may be desirable for the tunneling region 102 to have a distance dimension based on minimum spacing design rules to optimize MTP memory cell 100 programming and erasing performance, for example. For ease of illustration, the program-erase electrode PG-E is depicted as an orthogonally shaped electrode with corresponding extended portions of the floating gate FG separated by the tunneling region 102 in the embodiment of FIG. 1. In other embodiments, the program-erase electrode PG-E may have other suitable shapes with corresponding tunneling region spacing to the floating gate FG. Cross-sectional views of the program-erase structure 114 taken along line A-A are depicted in FIG. 2 and FIG. 3.

In this embodiment, the read transistor 116 portion of the MTP memory cell 100 includes a first well region 104 formed in the semiconductor substrate and a second well region 106 formed in the semiconductor substrate. A channel region 112 separates the well region 104 from the well region 106. A portion of the floating gate FG is formed over the channel region 112 and portions of the well regions 104 and 106 illustrated with dashed lines. In this embodiment, the well region 104 may be characterized as a source current electrode region, the well region 106 may be characterized as a drain current electrode region, and the portion of the floating gate FG formed over the channel region 112 may be characterized as a control gate electrode portion of the read transistor 116.

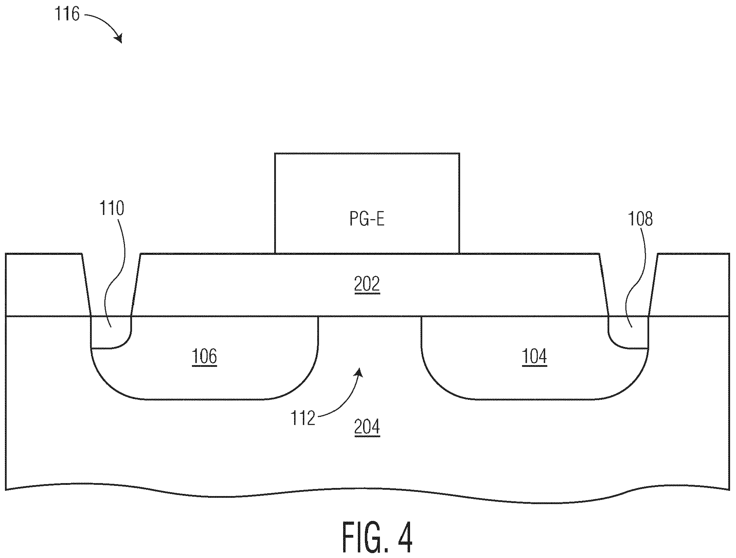

The read transistor 116 is configured to sense charge states (e.g., programmed, erased stored charge) of the floating gate FG during a read operation of the MTP memory cell 100. For example, the source electrode region may be coupled to a power supply node and the drain region may be coupled to a bit-line node during the read operation. A conduction path may be formed across the channel 112 based on the charge state (e.g. amount of stored charge) of the floating gate FG. Active regions 108 and 110 are formed in respective well regions 104 and 106 and are configured as connection locations to respective source and drain electrode regions of the read transistor 116, for example. In this embodiment, each of the well regions 104 and 106 are formed having an N-type conductivity characterized as N- (minus) and each of the active regions 108 and 110 are formed having an N-type conductivity characterized as N+ (plus). In other embodiments, the read transistor 116 may be formed with well regions and corresponding active regions having complementary (e.g., P-type) conductivity types. A cross-sectional view of the read transistor 116 taken along line B-B is depicted in FIG. 4.

In this embodiment, the control structure 120 of the MTP memory cell 100 includes a conductive control gate electrode CG formed substantially parallel and proximate (e.g., very close) to a portion of the floating gate FG. The control gate electrode CG is capacitively coupled to the floating gate FG. The control gate electrode CG and the floating gate FG are formed directly on the field oxide region of the semiconductor substrate. The field oxide region may be formed as a shallow trench isolation (STI) region or a local oxidation of silicon (LOCOS) region, for example. Lengthwise edges of the control gate electrode CG are spaced apart from edges of the floating gate FG by a tunneling region 118. It may be desirable for the tunneling region 118 to have a distance dimension (e.g., distance between CG and FG) based on minimum spacing design rules to optimize capacitive coupling between the control gate electrode CG and the floating gate FG, for example.

In this embodiment, the control gate electrode CG is formed in two segments with each segment formed on opposite sides of the floating gate FG. The two segments may be connected to one another by way of an interconnecting metal layer, for example. In some embodiments, the interconnecting metal layer may be formed over a lengthwise portion of the floating gate FG to provide additional coupling between the control gate electrode CG and the floating gate FG. In this embodiment, the control gate electrode CG may be formed from a polysilicon material, suitable metal material, or combination thereof. Likewise, the floating gate FG may be formed from a polysilicon material, suitable metal material, or combination thereof. The control gate electrode CG and the floating gate FG may be formed from same conductive materials or may be formed having different conductive materials from each other. In this embodiment, at least a portion of the gate electrode CG is formed in a same plane as the floating gate FG. An interlevel dielectric (ILD) material such as TEOS may be formed at a subsequent stage substantially filling the gap between the control gate electrode CG and the floating gate FG, for example.

FIG. 2 illustrates, in a simplified cross-sectional view, an example of the program-erase structure 114 take along line A-A in accordance with an embodiment. In this example, the program-erase structure 114 of the MTP memory cell 100 includes the conductive program-erase electrode PG-E labeled 208 and the conductive floating gate FG formed on the field oxide region 202 and separated from one another by the tunneling region 102. The field oxide region 202 may be formed from a suitable dielectric material (e.g., silicon dioxide). In this embodiment, the field oxide region 202 may be formed as a shallow trench portion of the semiconductor substrate 204 filled with a deposited dielectric material (e.g., STI region) or may be formed as a grown dielectric material at a top portion of the semiconductor substrate 204 (e.g., LOCOS region). In other embodiments, the field oxide region 202 may be formed using other techniques and methods. In this embodiment, the semiconductor substrate 204 may be formed as a P-type doped silicon substrate. The semiconductor substrate 204 may alternatively be formed from other suitable silicon-based substrates such as gallium arsenide, silicon germanium, silicon-on-insulator (SOI), monocrystalline silicon, the like, and combinations thereof, for example.

In this embodiment, the program-erase electrode PG-E 208 and the floating gate FG are formed directly on the top (e.g., exposed) surface of the field oxide region 202. The program-erase electrode PG-E 208 and the floating gate FG may be formed from a suitable conductive material such as a polysilicon material or a metal material, for example. In some embodiments, the program-erase electrode PG-E 208 and the floating gate FG are formed from a same material, and in some embodiments, may be formed during a same process operation. In other embodiments, the program-erase electrode PG-E 208 may be formed having different materials from that of the floating gate FG during different operations. The program-erase electrode PG-E 208 may be interconnected with other circuit features by way of contacts, vias, and conductive traces not shown for illustration purposes.

The program-erase electrode PG-E 208 is capacitively coupled to the floating gate FG. The program-erase electrode PG-E 208 and the floating gate FG are spaced apart from one another by the tunneling region 102 having a predetermined tunneling distance dimension 210. The distance dimension 210 is chosen to optimize MTP memory cell 100 programming and erasing performance, for example. In this embodiment, a dielectric spacer 206 is formed on the field oxide region 202 between the program-erase electrode PG-E 208 and the floating gate FG. The dielectric spacer 206 may be configured to at least fill a portion of the space between sidewalls of the program-erase electrode PG-E 208 and the floating gate FG. In this embodiment, the dielectric spacer 206 may be formed from a suitable nonconductive material such as silicon nitride.

In operation, program and erase voltages may be applied between the program-erase electrode PG-E 208 and the control gate electrode CG (FIG. 1) for respective programming and erasing functions of the MTP memory cell 100. For example, the program-erase electrode PG-E 208 may be configured and arranged to receive a programming voltage (e.g., relative to the control gate electrode CG) sufficient to form a tunneling current between the program-erase electrode PG-E 208 and the floating gate FG during a program operation. An erase operation may be performed by applying an erase voltage (e.g., programming voltage with opposite polarity) between the program-erase electrode PG-E 208 and the control gate electrode CG. Programming and erase voltages may be CMOS technology dependent and may vary accordingly with respective technology nodes. For example, with the MTP memory cell 100 formed at a 28 nanometer CMOS technology node, a programming voltage at or near 30 volts may be required to generate a suitable tunneling current. In smaller technology nodes, programming voltage requirements may be lower.

FIG. 3 illustrates, in a simplified cross-sectional view, an alternative example of the program-erase structure 114 in accordance with an embodiment. In this alternative example, the program-erase structure 114 of the MTP memory cell 100 includes the conductive program-erase electrode PG-E labeled 302 formed as a contact and separated from the floating gate FG by the tunneling region 102. A bottom portion of the program-erase electrode PG-E 302 may extend into a portion of the field oxide 202 and a top portion of the program-erase electrode PG-E 302 may extend above the plane of the floating gate FG. The program-erase electrode PG-E 302 may be formed from a suitable metal contact material such as tungsten, copper, gold, silver, aluminum, nickel, and alloys thereof, or polysilicon material for example.

In this embodiment, the program-erase electrode PG-E 302 is spaced apart from the floating gate FG by the tunneling 102 having a predetermined tunneling distance dimension 210. The dielectric spacer 206 is formed on the field oxide region 202 between the program-erase electrode PG-E 302 and the floating gate FG. The dielectric spacer 206 may be configured to at least fill a portion of the space between sidewalls of the program-erase electrode PG-E 302 and the floating gate FG. By forming the program-erase electrode PG-E 302 as a contact, greater flexibility in interconnection of the program-erase electrode PG-E 302 is facilitated.

FIG. 4 illustrates, in a simplified cross-sectional view, an example of the read transistor 116 take along line B-B in accordance with an embodiment. In this example, the read transistor 116 of the MTP memory cell 100 includes the first well region 104 and the second well region 106 formed in the semiconductor substrate. The channel region 112 separates the well region 104 from the well region 106. The floating gate FG is formed over the channel region 112 and portions of the well regions 104 and 106. In this embodiment, the read transistor may be characterized as a parasitic field transistor with the well region 104 serving as a source current electrode region and the well region 106 serving as a drain current electrode region.

Active regions 108 and 110 are formed in respective well regions 104 and 106 and are configured as connection locations to respective source and drain electrode regions of the read transistor 116, for example. In this embodiment, each of the well regions 104 and 106 are formed having an N-type conductivity characterized as N- (minus) and each of the active regions 108 and 110 are formed having an N-type conductivity characterized as N+ (plus). In other embodiments, the read transistor 116 may be formed with well regions and corresponding active regions having complementary (e.g., P-type) conductivity types.

In operation, a read voltage may be applied to the control gate electrode CG (FIG. 1), the source electrode region may be coupled to a power supply node and the drain region may be coupled to a bit-line node during a read function of the MTP memory cell 100. For example, the read transistor 116 is configured to sense stored charge (e.g., programmed, erased states) of the floating gate FG during a read operation. Accordingly, a conduction path may be formed across the channel 112 based on the state of charge (e.g. amount of stored charge) of the floating gate FG.

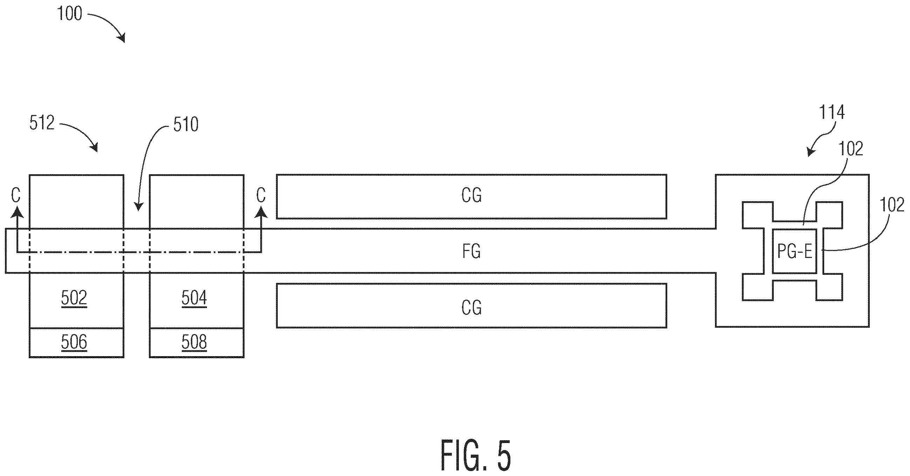

FIG. 5 illustrates, in a simplified plan view, the example MTP memory cell 100 having an alternative read transistor 512 configuration in accordance with an embodiment. In this embodiment, the MTP memory cell 100 includes the program-erase structure 114, the control structure 120, and the alternative read transistor structure 512 formed over the semiconductor substrate (not shown). Conductive feature such as metal traces, vias, etc. interconnected with features of the MTP memory cell 100 are not shown for illustration purposes.

In this embodiment, the read transistor 512 portion of the MTP memory cell 100 includes a first well region 502 formed in the semiconductor substrate and a second well region 504 formed in the semiconductor substrate. A channel region 510 separates the well region 502 from the well region 504. A portion of the floating gate FG is formed over the channel region 510 and portions of the well regions 502 and 504 illustrated with dashed lines. In this embodiment, the well region 502 may be characterized as a source current electrode region, the well region 504 may be characterized as a drain current electrode region, and the portion of the floating gate FG formed over the channel region 510 may be characterized as a control gate electrode portion of the read transistor 512.

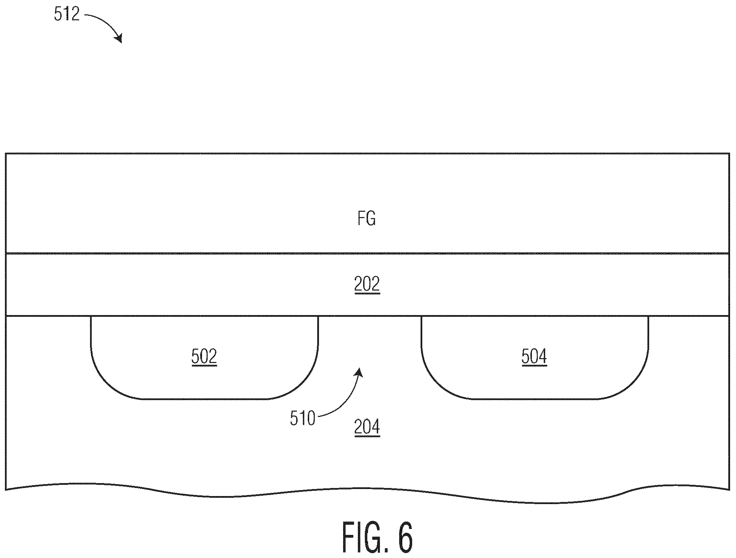

The read transistor 512 is configured to sense charge states (e.g., programmed, erased stored charge) of the floating gate FG during a read operation of the MTP memory cell 100. For example, the source electrode region may be coupled to a power supply node and the drain region may be coupled to a bit-line node during the read operation. A conduction path may be formed across the channel 510 based on the charge state (e.g. amount of stored charge) of the floating gate FG. Active regions 506 and 508 are formed in respective well regions 502 and 504 and are configured as connection locations to respective source and drain electrode regions of the read transistor 512, for example. In this embodiment, each of the well regions 502 and 504 are formed having an N-type conductivity characterized as N- (minus) and each of the active regions 506 and 508 are formed having an N-type conductivity characterized as N+ (plus). In other embodiments, the read transistor 512 may be formed with well regions and corresponding active regions having complementary (e.g., P-type) conductivity types. A cross-sectional view of the read transistor 512 taken along line C-C is depicted in FIG. 6.

FIG. 6 illustrates, in a simplified cross-sectional view, an example of the read transistor 512 take along line C-C in accordance with an embodiment. In this example, the read transistor 512 of the MTP memory cell 100 includes the first well region 502 and the second well region 504 formed in the semiconductor substrate 204. The channel region 510 separates the well region 502 from the well region 504. The floating gate FG is formed over the channel region 510 and portions of the well regions 502 and 504. In this embodiment, the read transistor may be characterized as a parasitic field transistor with the well region 502 serving as a source current electrode region and the well region 504 serving as a drain current electrode region.

In operation, a read voltage may be applied to the control gate electrode CG (FIG. 5), the source electrode region may be coupled to a power supply node and the drain region may be coupled to a bit-line node during a read function of the MTP memory cell 100. For example, the read transistor 512 is configured to sense stored charge (e.g., programmed, erased states) of the floating gate FG during a read operation. Accordingly, a conduction path may be formed across the channel 510 based on the state of charge (e.g. amount of stored charge) of the floating gate FG.

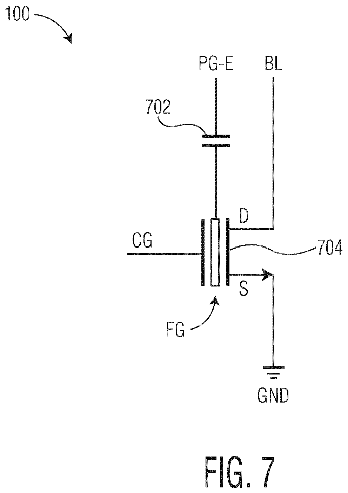

FIG. 7 illustrates, in a simplified schematic view, the example MTP memory cell 100 in accordance with an embodiment. The MTP non-volatile memory cell circuit depicted in FIG. 7 corresponds to the MTP memory cell 100 depicted in FIG. 1 and FIG. 5. In this embodiment, the MTP memory cell 100 includes a circuit representation of the program-erase, read, and control features of the memory cell.

The program-erase feature of the MTP memory cell 100 includes first terminal of capacitor 702 connected to the program-erase electrode labeled PG-E and a second terminal of the capacitor 702 connected to the floating gate labeled FG. The capacitor 702 is representative of the capacitive coupling between the program-erase electrode PG-E and the floating gate FG, for example.

The read feature of the MTP memory cell 100 includes a first current electrode labeled S (e.g., source) of floating gate transistor 704 coupled to a power supply node labeled GND (e.g., ground), a second current electrode labeled D (e.g., drain) coupled to a bit line node labeled BL, and the floating gate FG serving as a control electrode. For illustration purposes, circuitry such as select devices which may selectively couple the drain current electrode D to the bit line BL and select devices which may selectively couple the source current electrode S to the power supply node are not shown. The read feature of the transistor 704 is representative of the field transistor formed by the floating gate FG and well regions 104 and 106 of FIG. 1 and FIG. 4, for example.

The control feature of the MTP memory cell 100 includes a control gate electrode labeled CG capacitively coupled to the floating gate FG of the transistor 704. In this embodiment, the control gate electrode CG to floating gate FG capacitance is much, much, greater than the program-erase electrode PG-E to floating gate FG capacitance. For example, the CG-to-FG capacitance may be in a range of ten times (e.g., 10X) the PG-E-to-FG capacitance or greater.

In operation, program and erase voltages may be applied across the program-erase electrode PG-E and the control gate electrode CG for respective programming and erasing functions of the MTP memory cell 100. For example, with the MTP memory cell 100 formed at a 28 nanometer CMOS technology node, a program voltage of approximately 30 volts may be required to generate a suitable tunneling current to transfer charge to the floating gate FG. An erase voltage, approximately equal to the program voltage with an opposite polarity, may be required to discharge the floating gate. In some embodiments, a charged state of the floating gate FG may be representative of a stored 1 (one) logic level (e.g., programmed) and a discharged state of the floating gate FG may be representative of a stored 0 (zero) logic level (e.g., erased). In some embodiments, a discharged state of the floating gate FG may be representative of a stored 1 (one) logic level (e.g., erased) and a charged state of the floating gate FG may be representative of a stored 0 (zero) logic level (e.g., programmed). Reading (e.g., sensing) the value stored in the MTP memory cell 100 may be accomplished with a read voltage applied to the control gate electrode CG, the source current electrode S coupled to the power supply GND and the drain current electrode D coupled to the bit-line BL. For example, a conduction path may be formed across the drain-source channel based on the state of charge (e.g. programmed, erased) of the floating gate FG.

Generally, there is provided, a multi-time programmable memory cell including a floating gate formed on a field oxide region formed on a semiconductor substrate; a control gate formed on the field oxide region, the control gate located parallel to a first portion of the floating gate; a program-erase electrode formed on the field oxide region and proximate to a second portion of the floating gate; a first well region formed in the semiconductor substrate; and a second well region formed in the semiconductor substrate, a channel region formed between the first well region and the second well region, a third portion of the floating gate overlaying the channel region. The memory cell may further include a spacer dielectric formed on the field oxide region between the floating gate and the program-erase electrode. The program-erase electrode may be configured and arranged to receive a voltage sufficient to form a tunneling current between the program-erase electrode and the floating gate. The coupling capacitance between the control gate and the floating gate may be greater than coupling capacitance between the program-erase electrode and the floating gate. The first well region may be characterized as a source current electrode and the second well region may be characterized as a drain current electrode. The first well region may be configured for connection to a power supply and the second well region may be configured for connection to a bit line during a read operation of the memory cell. The field oxide region may be formed as a shallow trench isolation (STI) region or a local oxidation of silicon (LOCOS) region. The control gate and the floating gate each may include a polysilicon material. The program-erase electrode may be formed as a metal contact.

In another embodiment, there is provided, a method of forming multi-time programmable memory cell including forming a first well region in a semiconductor substrate; forming a second well region in the semiconductor substrate such that a channel region is formed between the first well region and the second well region; forming a field oxide region on the semiconductor substrate; forming a floating gate on the field oxide region, a first portion of the floating gate overlaying the channel region; forming a control gate on the field oxide region, the control gate located parallel to a second portion of the floating gate; and forming a program-erase electrode on the field oxide region, the program-erase electrode located proximate to a third portion of the floating gate. The method may further include forming a spacer dielectric on the field oxide region between the third portion of the floating gate and the program-erase electrode. The method may further include configuring the program-erase electrode to receive a voltage sufficient to form a tunneling current between the program-erase electrode and the floating gate. The method may further include configuring the first well region for connection to a power supply and configuring the second well region for connection to a bit line during a read operation of the memory cell. The forming the field oxide region may include forming a shallow trench isolation (STI) region or a local oxidation of silicon (LOCOS) region. The forming the floating gate on the field oxide region may include forming the floating gate from a polysilicon material.

Also disclosed is a multi-time programmable memory cell including a first well region having a first conductivity type, the first well region formed in a semiconductor substrate having a second conductivity type; a second well region having the first conductivity type, the second well region formed in the semiconductor substrate such that a channel region is formed between the first well region and the second well region; a field oxide region formed on the semiconductor substrate; a floating gate formed on the field oxide region such that a first portion of the floating gate is formed over the channel region; a control gate formed on the field oxide region, the control gate located parallel and proximate to a second portion of the floating gate; and a program-erase electrode formed on the field oxide region, the program-erase electrode located proximate to a third portion of the floating gate. The memory cell may further include a spacer dielectric formed on the field oxide region between the floating gate and the program-erase electrode. The program-erase electrode may be configured and arranged to receive a voltage sufficient to form a tunneling current between the program-erase electrode and the floating gate. The first well region may be configured for connection to a power supply and the second well region may be configured for connection to a bit line during a read operation of the memory cell. The field oxide region may be formed as a shallow trench isolation (STI) region or a local oxidation of silicon (LOCOS) region.

By now it should be appreciated that there has been provided, a multi-time programmable (MTP) non-volatile memory cell. Features such as floating gate, control gate, program-erase electrode, and read transistor of the MTP memory cell are all formed on a field oxide region. The program-erase electrode is separated from the floating gate by a predetermined tunneling distance. During programming and erasing operations, respective program or erase voltages are applied across the program-erase electrode and the control gate electrode. A read transistor is formed having a first well region as a source current electrode region, a second well region as a drain current electrode region, and a portion of the floating gate formed over a channel separating the first and second well regions. Reading the value stored in the MTP memory cell 100 may be performed with a read voltage applied to the control gate electrode, the source current electrode coupled to a power supply node, and the drain current electrode coupled to a bit-line. By forming the floating gate, control gate, program-erase electrode, and read transistor features of the MTP memory cell on the field oxide region (e.g., none of these features being formed on gate oxide), greater scalability with advance (e.g., smaller geometry) technology nodes may be readily accommodated.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A multi-time programmable memory cell comprising:
a floating gate formed on a field oxide region formed on a semiconductor substrate;
a control gate formed on the field oxide region, the control gate located parallel to a first portion of the floating gate;
a program-erase electrode formed on the field oxide region and proximate to a second portion of the floating gate;
a first well region formed in the semiconductor substrate; and
a second well region formed in the semiconductor substrate, a channel region formed between the first well region and the second well region, a third portion of the floating gate overlaying the channel region.

2. The memory cell of claim 1, further comprising a spacer dielectric formed on the field oxide region between the floating gate and the program-erase electrode.

3. The memory cell of claim 1 or 2, wherein the program-erase electrode is configured and arranged to receive a voltage sufficient to form a tunneling current between the program-erase electrode and the floating gate.

4. The memory cell of any preceding claim, wherein coupling capacitance between the control gate and the floating gate is greater than coupling capacitance between the program-erase electrode and the floating gate.

5. The memory cell of any preceding claim , wherein the first well region is characterized as a source current electrode and the second well region is characterized as a drain current electrode.

6. The memory cell of any preceding claim, wherein the first well region is configured for connection to a power supply and the second well region is configured for connection to a bit line during a read operation of the memory cell.

7. The memory cell of any preceding claim, wherein the field oxide region is formed as a shallow trench isolation, STI, region or a local oxidation of silicon, LOCOS, region.

8. The memory cell of any preceding claim, wherein the control gate and the floating gate each comprise a polysilicon material.

9. The memory cell of any preceding claim, wherein the program-erase electrode is formed as a metal contact.

10. A method of forming multi-time programmable memory cell, the method comprising:
forming a first well region in a semiconductor substrate;
forming a second well region in the semiconductor substrate such that a channel region is formed between the first well region and the second well region;
forming a field oxide region on the semiconductor substrate;
forming a floating gate on the field oxide region, a first portion of the floating gate overlaying the channel region;
forming a control gate on the field oxide region, the control gate located parallel to a second portion of the floating gate; and
forming a program-erase electrode on the field oxide region, the program-erase electrode located proximate to a third portion of the floating gate.

11. The method of claim 10, further comprising forming a spacer dielectric on the field oxide region between the third portion of the floating gate and the program-erase electrode.

12. The method of claim 10 or 11, further comprising configuring the program-erase electrode to receive a voltage sufficient to form a tunneling current between the program-erase electrode and the floating gate.

13. The method of any one of claims 10 to 12, further comprising configuring the first well region for connection to a power supply and configuring the second well region for connection to a bit line during a read operation of the memory cell.

14. The method of any one of claims 10 to 13, wherein forming the field oxide region includes forming a shallow trench isolation (STI) region or a local oxidation of silicon (LOCOS) region.

15. The method of any one of claims 10 to 14, wherein forming the floating gate on the field oxide region includes forming the floating gate from a polysilicon material.
